# EUROPÄISCHE PATENTANMELDUNG

(11) **EP 2 468 826 A1**
(43) Veröffentlichungstag der Anmeldung: **27.06.2012**
(21) Anmeldenummer: 10196109.2
(22) Anmeldetag: 21.12.2010
(51) Int. Cl.: C09D 5/24, B22F 9/24, H01B 1/22, H05K 1/09

(54) **Pickering-Emulsion zur Herstellung elektrisch leitfähiger Beschichtungen und Verfahren zur Herstellung einer Pickering-Emulsion**

(71) Anmelder: Bayer MaterialScience AG, 51368 Leverkusen (DE)
(72) Erfinder: Rudhardt, Daniel Dr., 50827, Köln (DE); Eiden, Stefanie Dr., 51371, Leverkusen (DE); Landen, Diana, 51373, Leverkusen (DE); Gordon Duff, Daniel, 51373, Leverkusen (DE)

(57) **Zusammenfassung**

Die vorliegende Erfindung betrifft ein Verfahren zur Herstellung einer Pickering-Emulsion enthaltend Wasser, ein mit Wasser nicht mischbares Lösungsmittel sowie, bevorzugt sterisch, stabilisierte Silbernanopartikel zur Herstellung leitfähiger Beschichtungen. Die Erfindung betrifft weiterhin ein Verfahren zur voll- oder teilflächigen Beschichtung von Oberflächen, insbesondere mit einer erfindungsgemäßen Pickering-Emulsion, wobei die erhaltene Beschichtung insbesondere eine hohe elektrische Leitfähigkeit aufweisen und vorteilhafterweise zusätzlich transparent sein kann.

## Beschreibung

Die vorliegende Erfindung betrifft ein Verfahren zur Herstellung einer Pickering-Emulsion enthaltend Wasser, ein mit Wasser nicht mischbares Lösungsmittel sowie, bevorzugt sterisch, stabilisierte Silbernanopartikel zur Herstellung leitfähiger Beschichtungen. Die Erfindung betrifft weiterhin ein Verfahren zur voll- oder teilflächigen Beschichtung von Oberflächen, insbesondere mit einer erfindungsgemäßen Pickering-Emulsion, wobei die erhaltene Beschichtung insbesondere eine hohe elektrische Leitfähigkeit aufweisen und vorteilhafterweise zusätzlich transparent sein kann.

Kunststoffbauteile besitzen in der Regel gute mechanische und teilweise zusätzlich gute optische Eigenschaften, wie etwa die Transparenz bei Polycarbonat. Die meisten technischen Kunststoffe sind aber elektrische Isolatoren.

Die Verknüpfung von mechanischen Eigenschaften wie Stabilität, optischen Eigenschaften wie Transparenz und elektrischen Eigenschaften wie elektrischer Leitfähigkeit bei transparenten Kunststoffen ist für viele Anwendungen wünschenswert und kann enorme Vorteile bringen. Hervorzuheben ist hierbei die Transparenz von Bauteilen, die in vielen Anwendungsbereichen möglichst hoch sein soll, zum Beispiel für Scheiben im Automobilbau oder an Gebäuden, oder für Sichtfenster in Geräten, die mit erweiterten elektrischen Anwendungen gekoppelt werden sollen, wie zum Beispiel elektrischer Beheizung, Abschirmung elektromagnetischer Strahlung oder Ableitung von Oberflächenladung. Gleichzeitig soll in den meisten Fällen die mechanische Stabilität des Grundwerkstoffes wie auch die Designfreiheit hinsichtlich der Formgebung möglichst hoch sein. Auch der Einsatz im Bereich der Solarzellentechnik (Photovoltaikanlagen) als hochleitfähiger elektrischer Leiter ist erstrebenswert.

In der Verarbeitung von Silber oder anderen Metallen ist es bekannt, stabilisierte Nanopartikel in organischen Lösungsmitteln oder in Wasser zu dispergieren und diese Formulierungen nachfolgend auf Substrate aufzubringen und zu trocknen. Es werden jedoch meist vergleichsweise hohe Temperaturen benötigt, um die stabilisierten Nanopartikel zu sintern. Dies ist jedoch nicht mit allen Substraten, insbesondere nicht mit vielen Kunststoffsubstraten, wie solchen aus Polycarbonat, verträglich.

Xia et al. beschreibt in Adv. Mater., 2003, 15, No.9, 695 - 699 die Herstellung von stabilen wässrigen Dispersionen von Silber-Nanopartikeln mit Poly(vinyl-pyrrolidon) (PVP) und Natriumcitrat als Stabilisatoren. Xia erhält so monodisperse Dispersionen mit Silber-Nanopartikeln mit Partikelgrößen unterhalb von 10 nm und enger Partikelgrößenverteilung. Die Verwendung von PVP als polymerem Stabilisator führt dabei zu sterischer Stabilisierung der Nanopartikel gegen Aggregation. Solche sterischen polymeren Dispersionsstabilisatoren können gegebenenfalls in den erhaltenen leitfähigen Beschichtungen durch die Oberflächenbelegung der Silberpartikel den direkten Kontakt der Partikel zueinander und damit die Leitfähigkeit der Beschichtung verringern. Laut Xia gelingt es nicht, solche stabilen monodispersen Dispersionen ohne den Einsatz von zusätzlichem PVP als Stabilisator zu erhalten.

Die EP 1 493 780 A1 beschreibt die Herstellung leitfähiger Oberflächenbeschichtungen mit einer flüssigen leitfähigen Zusammensetzung aus einem Binder und Silberpartikeln, wobei vorgenannte silberhaltige Partikel Silberoxidpartikel, Silbercarbonatpartikel oder Silberacetatpartikel sein können, welche jeweils eine Größe von 10 nm bis 10 µm aufweisen können. Der Binder ist eine polyvalente Phenolverbindung oder einer von verschiedenen Harzen, also in jedem Fall mindestens eine zusätzliche polymere Komponente. Gemäß der EP 1 493 780 A1 wird aus dieser Zusammensetzung nach Aufbringen auf eine Oberfläche unter Erhitzen eine leitfähige Schicht erhalten, wobei das Erhitzen bevorzugt bei Temperaturen von 140°C bis 200°C auszuführen ist. Die gemäß der EP 1 493 780 A1 beschriebenen leitfähigen Zusammensetzungen sind Dispersionen in einem Dispersionsmittel, ausgewählt aus Alkoholen, wie Methanol, Ethanol und Propanol, Isophoronen, Terpineolen, Triethylenglykolmonobutylethern und Ethylenglykol-Monobutylether-Acetat. Hierbei wird in der EP 1 493 780 A1 darauf hingewiesen, dass die silberhaltigen Partikel im Dispersionsmittel bevorzugt durch Zugabe von Dispersionsstabilisatoren wie Hydroxypropylcellulose, Polyvinylpyrrolidon und Polyvinylalkohol vor einer Aggregation zu schützen sind. Auch diese Dispersionsstabilisatoren sind polymere Komponenten. Die silberhaltigen Partikel werden demnach im Dispersionsmittel stets sterisch durch die vorgenannten Dispersionsstabilisatoren und den Binder als Dispersionsstabilisator gegen eine Aggregation stabilisiert.

Eine Methode zur Herstellung von transparenten leitfähigen Metall-Nanopartikel-basierten Beschichtungen wird in der WO2006/13735 A2 und in der US 7,566,360 B2 offenbart. Hierbei wird zunächst ein Nano-Metallpulver mit mehreren Additiven, wie oberflächenaktiven Substanzen, Bindern, Polymeren, Puffern, Dispergierhilfsmitteln und Kupplungsreagenzien, in organischen Lösungsmitteln zu einer homogenen Mischung verarbeitet. Die Nano-Metallpulver können auch Silbernanopartikel sein. Diese homogene Mischung wird dann wiederum mit Wasser oder einem mit Wasser mischbaren Lösungsmittel gemischt, so dass eine Wasser-in-Öl(W/O)-Emulsion erhalten wird. Diese Emulsion wird direkt durch Sprühen, Drucken, Spin Coating oder Dippen auf die zu beschichtende Oberfläche aufgebracht, die Lösungsmittel werden entfernt und die Beschichtung wird gesintert, wobei eine leitfähige und transparente Beschichtung oder Struktur erhalten wird.

Beschrieben wird auch die Ausbildung von netzwerkartigen Strukturen durch die Metall-Nanopartikel.

Die Selbstorganisation von CNTs (Carbonanotubes) bzw. SWNTs (Singe Walled Carbo-Nanotubes) zu einer Wabenstruktur mittels Emulsionstechnik wurde durch N. Wakamatsu et al. in Ad. Funct.Mater.2007, 19, 2535-2539 beschrieben.

In der Veröffentlichung von Minzhi Rong, Polymer 40 (1999) 6169, ist die Selbstorganisation von Silbernanopartikeln in polymereren Systemen beschrieben.

Es besteht weiterhin Bedarf an alternativen Verfahren zur Beschichtung von Oberflächen mit leitfähigen Beschichtungen unter Einsatz von Dispersionen enthaltend Silbernanopartikel, bei denen kurze Trocknungs- und Sinterzeiten und/oder niedrige Trocknungs- und Sintertemperaturen zum Einsatz kommen können, so dass auch temperaturempfindliche Kunststoffoberflächen beschichtet werden können. Wünschenswert sind zudem auch alternative Beschichtungsmittel zur Herstellung elektrisch hoch leitfähiger Beschichtungen, die insbesondere zusätzlich eine gute Transparenz aufweisen können, sowie kostengünstige und einfache Verfahren zu deren Herstellung.

Erfindungsgemäß wird daher ein Verfahren zur Herstellung einer Pickering-Emulsion zur Herstellung leitfähiger Beschichtungen vorgeschlagen, wobei
a) eine wässrige Dispersion enthaltend, insbesondere sterisch, stabilisierte Silbernanopartikel und Wasser mit wenigstens einem, nicht mit Wasser mischbaren, Lösungsmittel gemischt und anschließend zu einer Emulsion dispergiert wird, wobei der Gehalt an stabilisierten Silbernanopartikeln, bezogen auf das Gesamtgewicht der erhaltenen Emulsion, zwischen 0,5 Gew.-% und 7 Gew.-% liegt, und
b) anschließend während einer Standzeit die in (a) erhaltene Emulsion durch eine Aufrahmung in eine obere aufkonzentrierte Emulsionsphase und eine untere, im Wesentlichen wässrige, Phase separiert wird, und
c) die erhaltene obere aufkonzentrierte Emulsionsphase isoliert wird, wobei diese Emulsionsphase einen Gehalt an Silbernanopartikeln bis zu 7 Gew-%, bevorzugt bis zu 4,5 Gew.-%, bezogen auf deren Gesamtgewicht, aufweist.

Mit anderen Worten wird im erfindungsgemäßen Schritt (a) eine Ursprungsemulsion aus in wässrigem Dispersionsmittel bzw. wässrigen Dispersionsmitteln dispergierten stabilisierten Silbernanopartikeln, beispielsweise ein Silbernanopartikel-Sol, Wasser und einem nicht mit Wasser mischbaren Lösungsmittel hergestellt. Diese Ursprungsemulsion kann bevorzugt eine O/W-Emulsion sein. Die Ölphase der O/W-Emulsion wird in diesem Fall durch das bzw. die nicht mit Wasser mischbare/n Lösungsmittel gebildet.

Die Silbernanopartikel belegen die Oberfläche der Öltropfen und stabilisieren die Öltropfen in der Emulsion. Der angegebene Gehalt an Silbernanopartikeln in Gew.-% bezieht sich erfindungsgemäß auf den Gehalt an stabilisierten Silbernanopartikeln, also der Silbernanopartikel, die mit Dispersionsstabilisator auf ihrer Oberfläche belegt sind.

Bei dem oder den wässrigen Dispersionsmittel(n) handelt es sich bevorzugt um Wasser oder Mischungen enthaltend Wasser und organische, vorzugsweise wasserlösliche, Lösungsmittel. Besonders bevorzugt handelt es sich bei dem oder den flüssigen Dispersionsmittel(n) um Wasser oder Mischungen aus Wasser mit Alkoholen, Aldehyden und/oder Ketonen, besonders bevorzugt um Wasser oder Mischungen aus Wasser mit ein- oder mehrwertigen Alkoholen mit bis zu vier Kohlenstoffatomen, wie z.B. Methanol, Ethanol, n-Propanol, iso-Propanol oder Ethylenglykol, Aldehyden mit bis zu vier Kohlenstoffatomen, wie z.B. Formaldehyd, und/oder Ketonen mit bis zu vier Kohlenstoffatomen, wie z.B. Aceton oder Methylethylketon. Ganz besonders bevorzugtes Dispersionsmittel ist Wasser.

Unter Silbernanopartikeln im Rahmen der Erfindung sind solche mit einem d₅₀-Wert von weniger als 100 nm, bevorzugt weniger als 80 nm, gemessen mittels dynamischer Lichtstreuung, zu verstehen. Für die Messung mittels dynamischer Lichtstreuung eignet sich beispielsweise ein ZetaPlus Zeta Potential Analyzer der Fa. Brookhaven Instrument Corporation.

Die Stabilisierung der Silbernanopartikel in der eingesetzten wässrigen Silbernanopartikeldispersion, beispielsweise Silbernanopartikel-Sol, erfolgt erfindungsgemäß bevorzugt mit einem sterischen Dispergierhilfsmittel, wie z.B Polyvinylpyrrolidon, Blockcopolyether und Blockcopolyether mit Polystyrolblöcken, ganz besonders bevorzugt Disperbyk 190 (Firma BYK-Chemie, Wesel).

Durch den Einsatz eines Dispergierhilfsmittels weisen die zur Herstellung der erfindungsgemäßen Pickering-Emulsion eingesetzten Silbernanopartikel-Sole eine hohe kolloid-chemische Stabilität auf. Die Wahl des Dispergierhilfsmittels erlaubt es auch, die Oberflächeneigenschaften der Partikel optimal einzustellen. Auf der Partikeloberfläche haftendes Dispergierhilfsmittel kann beispielsweise den Partikeln eine positive oder negative Oberflächenladung verleihen.

Es ist grundsätzlich auch möglich, jedoch erfindungsgemäß weniger bevorzugt, die Silbernanopartikel elektrostatisch zu stabilisieren. Zur elektrostatischen Stabilisierung der Silbernanopartikel wird bei der Herstellung der Dispersionen wenigstens ein elektrostatischer Dispersionsstabilisator zugegeben. Unter einem elektrostatischen Dispersionsstabilisator im Sinne der Erfindung ist ein solcher zu verstehen, durch dessen Anwesenheit die Silbernanopartikel mit abstoßenden Kräften versehen werden und auf Basis dieser abstoßenden Kräfte nicht mehr zu einer Aggregation neigen. Es herrschen folglich durch die Anwesenheit und Wirkung des elektrostatischen Dispersionsstabilisators zwischen den Silbernanopartikeln abstoßende elektrostatische Kräfte, die den auf die Aggregation der Silbernanopartikel hinwirkenden Van-der-Waals-Kräften entgegenwirken.

Besonders bevorzugte elektrostatische Dispersionsstabilisatoren sind Zitronensäure oder Citrate, wie z.B. Lithium-, Natrium-, Kalium- oder Tetramethylammoniumcitrat. In einer wässrigen Dispersion liegen die salzartigen elektrostatischen Dispersionsstabilisatoren weitestgehend in ihre Ionen dissoziiert vor, wobei die jeweiligen Anionen die elektrostatische Stabilisierung bewirken.

In Schritt (b) wird die Ursprungsemulsion aus Schritt (a) einer Aufrahmung unterworfen. Hierbei trennt sich die Ursprungsemulsion während einer Standzeit in eine obere aufkonzentrierte Emulsionsphase und in eine untere, im Wesentlichen wässrige, Emulsionsphase auf. Die obere aufkonzentrierte Emulsionsphase wird erfindungsgemäß auch als Rahmphase oder auch Rahmschicht bezeichnet. Die Rahmphase enthält mit anderen Worten vorteilhafterweise eine höhere Konzentration an Tropfen der Ölphase, da die Öltropfen während der Standzeit aufsteigen.

Im Schritt (c) des erfindungsgemäßen Verfahrens wird schließlich die Rahmphase isoliert. Die Rahmphase kann dabei einen Gehalt an stabilisierten Silbernanopartikeln von bis zu 7 Gew.-%, bevorzugt bis 4,5 Gew.-%, bezogen auf das Gesamtgewicht der isolierten Pickering-Emulsion, enthalten.

Mit anderen Worten wird die erfindungsgemäße Pickering-Emulsion durch die Rahmphase gebildet. Die Öltropfen in der Rahmphase sind dabei weiterhin durch die Silbernanopartikel auf ihrer Oberfläche belegt, wodurch vorteilhafterweise eine ausreichende Konzentration an Silber in die Rahmphase gelangt. Damit kann erfindungsgemäß gewährleistet werden, dass das erhaltene Beschichtungsmittel zur Herstellung von leitfähigen Beschichtungen geeignet ist.

Bei vergleichsweise niedrigen Ausgangskonzentrationen an Silbernanopartikeln in der Ursprungsemulsion kann vorteilhafterweise erfindungsgemäß auch die Konzentration an Silbernanopartikeln in der Rahmphase gegenüber der Konzentration in der Ursprungsemulsion in der Rahmphase erhöht sein. Dies ist besonders im Hinblick auf einen kosteneffizienten Beschichtungsprozess von Vorteil, da so erfindungsgemäß mit vergleichsweise geringem Einsatz an Silbernanopartikeln für geeignete Beschichtungsmittel für die Herstellung leitfähiger Beschichtungen erhalten werden können.

Das erfindungsgemäße Verfahren zur Herstellung des Beschichtungsmittels, also der Pickering-Emulsion, ist einfach und kostengünstig durchzuführen. Es hat sich überraschend gezeigt, dass die mit dem erfindungsgemäßen Verfahren bereitgestellten Pickering-Emulsionen darüber hinaus besonders stabil sind und beispielsweise über mehrere Tage gelagert werden können. Ein weiterer Vorteil des erfindungsgemäßen Verfahrens ist, dass die in Schritt (c) gewonnene Pickering-Emulsion hervorragend als Beschichtungsmittel zur Herstellung von elektrisch leitfähigen, insbesondere auch transparenten, Beschichtungen auf Substraten geeignet ist.

Weiterhin kann bei dem erfindungsgemäßen Verfahren vorteilhafterweise auf den Einsatz zusätzlicher Additive, wie Binder, Dispergierhilfsmittel und Filmbildner, verzichtet werden, welche die Trocknung und/oder Sinterung einer aus einer erfindungsgemäßen Pickering-Emulsion aus Schritt (c) erhaltenen Oberflächenbeschichtung verlangsamen, oder sogar eine erhöhte Temperatur benötigen, bis eine Trocknung und/oder Sinterung und damit eine Leitfähigkeit der Oberflächenbeschichtung durch Versinterung der Silberpartikel eintritt.

In einer bevorzugten Ausführungsform des Verfahrens ist vorgesehen, dass die Standzeit unter (b) 1 h bis 5 d, bevorzugt 6 h bis 3 d, besonders bevorzugt 12 h bis 36 h, beispielsweise 24 h, beträgt. Diese Standzeiten haben sich als besonders geeignet zur Bildung stabiler Pickering-Emulsionen mit guten Eigenschaften zur Herstellung von leitfähigen Beschichtungen herausgestellt.

In einer weiteren bevorzugten Ausgestaltung des Verfahrens liegt der Gehalt der Silbernanopartikel der Ursprungsemulsion unter (a), bezogen auf das Gesamtgewicht der unter (a) erhaltenen Ursprungsemulsion, bevorzugt zwischen 0,7 Gew.-% und 6,5 Gew.-%., besonders bevorzugt zwischen 0,7 und 3,0 Gew.-%. Durch die Einstellung des Silbernanopartikelgehalts in diesem bevorzugten Bereich können in den nachfolgenden Schritten (b) und (c) Pickering-Emulsionen erhalten und isoliert werden, die besonders vorteilhafte Eigenschaften zur Ausbildung von elektrisch leitfähigen Beschichtungen zeigen. Insbesondere wird durch die Einstellung des Silbergehalts in der Ursprungsemulsion in diesem bevorzugten Bereich nach der Auftragung der in (c) isolierten Pickering-Emulsion als Beschichtungsmittel auch die Selbstorganisation der Silbernanopartikel zu netzartigen Strukturen gefördert, beispielsweise die Ausbildung von Wabenstrukturen aus diesen Nanopartikeln in einer solchen Beschichtung. Darüber hinaus ist es möglich, dass die aus diesen, erfindungsgemäß bevorzugten, Ursprungsemulsionen erhaltenen Pickering-Emulsionen auch an Silbernanopartikeln angereichert sind und einen zur Ursprungsemulsion höheren Silbernanopartikelgehalt aufweisen können.

Hinsichtlich weiterer Merkmale des erfindungsgemäßen Verfahrens wird hiermit explizit auf die Erläuterungen im Zusammenhang mit der erfindungsgemäßen Pickering-Emulsion und der erfindungsgemäßen Verwendung verwiesen.

Erfindungsgemäß wird zur Lösung der erfindungsgemäßen Aufgabe weiterhin eine Pickering-Emulsion zur Herstellung leitfähiger Beschichtungen vorgeschlagen, wobei die Emulsion stabilisierte Silbernanopartikel, Wasser sowie wenigstens ein organisches, nicht mit Wasser mischbares Lösungsmittel enthält, wobei die stabilisierten Silbernanopartikel in einer Menge von 0,5 Gew.-% bis 7 Gew.-%, bevorzugt 0,7 bis 6,5 Gew.-%, besonders bevorzugt bis 5 Gew.-%, beispielsweise bis 3,5 Gew.-%, bezogen auf das Gesamtgewicht der Emulsion, enthalten sind.

Die erfindungsgemäß bereitgestellte Pickering-Emulsion ist als Beschichtungsmittel zur Erzeugung von elektrisch leitfähigen Strukturen, insbesondere zur Ausbildung von netzartigen Wabenstrukturen durch Selbstorganisation der Silbernanopartikel geeignet und kann vorteilhafterweise auch zur Herstellung von transparenten elektrisch leitfähigen Strukturen eingesetzt werden, insbesondere von durchgängig verbundenen transparenten leitfähigen Netzwerken. Vorteile der Selbstorganisation der Silbernanopartikel zu Wabenstrukturen liegen darin, dass kein aufwändiger Druckprozess oder kostenintensive Technologien erforderlich sind, um elektrisch leitfähige Strukturen zu erhalten. Darüber hinaus sind die Wabenstrukturen transparent und/oder tragen dazu bei, die Transparenz der ausgebildeten strukturierten Beschichtung zu verbessern.

Wie vorstehend schon im Rahmen der Beschreibung des Herstellungsverfahrens erläutert, enthält die erfindungsgemäße Pickering-Emulsion als Beschichtungsmittel vorzugsweise kleine sterisch stabilisierte Silbernanopartikel, die im Wesentlichen einen d₅₀ von ca. 80 nm aufweisen und im eingesetzten Silbernanopartikelsol kolloidal stabil vorliegen. Die stabilisierten Silbernanopartikel sind mit einer erfindungsgemäß niedrigen Konzentration von 0,5 Gew.-% bis 7 Gew.-%, bevorzugt von 0,5 bis 5 Gew.-%, besonders bevorzugt bis 4,5 Gew.-%, beispielsweise bis 3,5 Gew.-%, ohne zusätzliche Dispergierhilfmittel in der Pickering-Emulsion enthalten. Vermutlich auch durch diese niedrige Konzentration genügt eine niedrige Nachbehandlungstemperatur von 140 °C, um nach Auftrag und Trocknung der Pickering-Emulsion als Beschichtungsmittel auf einem Substrat überraschend hohe Leitfähigkeiten der ausgebildeten Strukturen zu erzielen.

In einer bevorzugten Ausführungsform der erfindungsgemäßen Pickering-Emulsion ist damit vorgesehen, dass diese keine zusätzlichen oberflächenaktiven Verbindungen, Bindemittel, Polymere, Puffer, Filmbildner oder Dispergiermittel enthält. Vorteilhafterweise ist die erfindungsgemäße Pickering-Emulsion daher frei von zusätzlichen Substanzen, welche die Leitfähigkeit einer daraus erzeugten Beschichtung vermindern könnten.

Dieses bedeutet, dass keine Additive, insbesondere keine zusätzlichen oberflächenaktiven Verbindungen, Bindemittel, Polymere, Puffer oder Dispergiermittel hinzugefügt werden müssen, um eine zur Herstellung von elektrisch leitfähigen Beschichtungen geeignete Pickering-Emulsion zu erhalten. Daher weist die erfindungsgemäße Pickering-Emulsion den weiteren Vorteil auf, dass sie gegenüber Beschichtungsmitteln, die zusätzliche Additive, wie oberflächenaktive Verbindungen, weitere Dispergierhilfsmittel oder Polymere, aufweisen, nicht nur kostengünstiger, sondern auch einfacher herzustellen ist. Vorteilhaft ist auch, dass eine sterische Hinderung der Silberpartikel durch solche zusätzlichen Additive vermieden wird und eine gute Leitfähigkeit einer aus der erfindungsgemäßen Pickering-Emulsion erzeugten Beschichtung, insbesondere auch bei vergleichsweise niedrigen Nachbehandlungstemperaturen, gewährleistet werden kann.

In einer bevorzugten Ausführungsform der erfindungsgemäßen Pickering-Emulsion handelt es sich bei dem organischen Lösungsmittel um wenigstens ein lineares oder verzweigtes Alkan, ein gegebenenfalls Alkyl-substituiertes Cycloalkan, ein Alkylacetat oder ein Keton, Benzol oder Toluol. Beispiele für erfindungsgemäß geeignete organische Lösungsmittel sind Cyclohexan, Methylcyclohexan, n-Hexan, Octadecan, Ethylacetat, Butylacetat, Acetophenon und Cyclohexanon, wobei diese Aufzählung nicht abschließend zu verstehen ist. Mit diesen Lösungsmitteln als Ölphase konnten erfindungsgemäß stabile Pickering-Emulsionen hergestellt werden, die besonders gut als Beschichtungsmittel zur Erzeugung von elektrisch leitfähigen Strukturen, insbesondere zur Ausbildung von netzartigen Wabenstrukturen durch Selbstorganisation der Silbernanopartikel geeignet sind.

In einer weiteren bevorzugten Ausgestaltung der erfindungsgemäßen Pickering-Emulsion ist vorgesehen, dass das organische Lösungsmittel und das Wasser in der Emulsion bevorzugt in einem Verhältnis (in Gew.-%) von 1:4 bis 1:2, beispielsweise in einem Verhältnis von 1:3, enthalten sind.

Im Rahmen einer bevorzugten Ausführungsform der Pickering-Emulsion nach der Erfindung sind die in die Pickering-Emulsion, beispielsweise in Form eines Silbernanopartikelsols, eingebrachten Silbernanopartikel sterisch durch ein Dispergierhilfsmittel stabilisiert. Das Dispergierhilfsmittel zur sterischen Stabilisierung ist erfindungsgemäß bevorzugt ausgewählt aus der Reihe: Polyvinylpyrrolidon, Blockcopolyether und Blockcopolyether mit Polystyrolblöcken. Besonders bevorzugt werden Polyvinylpyrrolidon mit Molmasse von etwa 10000 amu (z. B. PVP K15 der Firma Fluka) und Polyvinylpyrrolidon mit Molmasse von etwa 360000 amu (z. B. PVP K90 der Firma Fluka) und besonders bevorzugt Block-Copolyether mit Polystyrolblöcken, mit 62 Gew.-% C₂-Polyether, 23 Gew.-% C₃-Polyether und 15 Gew.-% Polystyrol, bezogen auf das getrocknete Dispergierhilfsmittel, mit einem Verhältnis der Blocklängen C₂-Polyether zu C₃-Polyether von 7:2 Einheiten (z. B. Disperbyk 190 der Firma BYK-Chemie, Wesel) eingesetzt.

Bevorzugt ist das Dispergierhilfsmittel in einer Menge von bis 10 Gew.-%, bevorzugt von 3 Gew.-% bis 6 Gew.-%, bezogen auf den Silbergehalt auf den Partikeln, vorhanden. Durch die Auswahl eines solchen Konzentrationsbereiches ist einerseits sichergestellt, dass die Teilchen so weit mit Dispergierhilfsmittel bedeckt werden, dass die gewünschten Eigenschaften, wie zum Beispiel Stabilität der Emulsion, gewährleistet sind. Andererseits vermeidet man erfindungsgemäß damit eine übermäßige Umhüllung der Teilchen mit dem Dispergierhilfsmittel. Ein unnötiger Überschuss an Dispergierhilfsmittel könnte in unerwünschter Weise die Eigenschaften der zu erzeugenden Pickering-Emulsion sowie der daraus herzustellenden Beschichtungen negativ beeinflussen. Weiterhin kann ein Zuviel an Dispergierhilfsmittel nachteilig für die kolloidale Stabilität der Teilchen sein und behindert gegebenenfalls die Weiterverarbeitung. Zudem kann ein Überschuss an Dispergierhilfsmitteln die Leitfähigkeit der aus den Pickering-Emulsionen erzeugten Beschichtungen herabsetzen oder sogar eine Isolierung verursachen. Alle vorstehend genannten Nachteile werden erfindungsgemäß vorteilhafterweise vermieden.

Hinsichtlich weiterer Merkmale der erfindungsgemäßen Pickering-Emulsion wird hiermit explizit auf die Erläuterungen im Zusammenhang mit dem erfindungsgemäßen Verfahren und der erfindungsgemäßen Verwendung verwiesen.

Die Erfindung betrifft weiterhin ein Verfahren zum voll- oder teilflächigen Beschichten von Oberflächen, wobei
AA) eine erfindungsgemäße Pickering-Emulsion voll- oder teilflächig auf eine Oberfläche aufgebracht wird,
AB) die so beschichtete Oberfläche anschließend mit einer Abdeckung derart abgedeckt wird, dass Wasser- und Lösungsmittel entweichen können,
AC) die so abgedeckte, beschichtete Oberfläche anschließend zur Entfernung des Wassers und des organischen Lösungsmittels bei wenigstens einer Temperatur von weniger als 40 °C getrocknet wird,
AD) die so getrocknete Beschichtung anschließend in Gegenwart oder Abwesenheit der Abdeckung gesintert wird.

Die Aufbringung der erfindungsgemäßen Pickering-Emulsion in Schritt (AA) kann beispielsweise durch Spray-Coating, Dippen, Fluten oder Aufrakeln erfolgen. Beispielsweise kann die Pickering-Emulsion auch mittels einer Pipette aufgetragen werden. Beim Aufbringen der erfindungsgemäßen Pickering Emulsion hat sich überraschend gezeigt, dass die mit Silbernanopartikeln ummantelten Öltropfen erhalten bleiben, was die Selbstorganisation der Silbernanopartikel sowie die Ausbildung von Wabenstrukturen hieraus vorteilhaft beeinflusst. Eine gute Selbstorganisation der Silbernanopartikel ermöglicht die Ausbildung durchgängiger Strukturen, wobei auf aufwändige Druckprozesse oder kostenintensive Technologien zu deren Erzeugung vorteilhafterweise verzichtet werden kann.

Mittels der Abdeckung, die in Schritt (AB) auf die mit der Pickering-Emulsion beschichtete Oberfläche aufgelegt wird, kann vorteilhafterweise zum einen die Geschwindigkeit der Trocknung der Nassschicht gezielt günstig beeinflusst werden, so dass ein durchgängiges Netzwerk aus Silbernanopartikeln gebildet werden kann. Zum anderen wurde überraschend festgestellt, dass die Abdeckung zudem die Selbstorganisation der Silbernanopartikel, insbesondere zu wabenförmigen Strukturen aus den Silberpartikeln fördert. Durch die Ausbildung von Wabenstrukturen aus Silbernanopartikeln kann erfindungsgemäß neben einer guten Leitfähigkeit vorteilhafterweise auch eine gute Transparenz erzielt werden.

Zur Entfernung des Wassers und des organischen Lösungsmittels wird unter Schritt (AC) eine Trocknung bei wenigstens einer Temperatur unterhalb von 40 °C durchgeführt. Es hat sich gezeigt, dass bei diesen insbesondere thermisch wenig belastenden Trocknungsbedingungen und dem damit einhergehenden langsamen Abdampfen des Wassers und des organischen Lösungsmittels besonders gute Bedingungen zur Bildung der gewünschten Wabenstrukturen durch die Silbernanopartikel geschaffen werden konnten. Weiterhin sind die Trocknungsbedingungen auch für Kunststoffsubstrate geeignet.

Im Rahmen einer bevorzugten Ausführungsform des Verfahrens ist vorgesehen, dass die Trocknung unter (AC) bei wenigstens einer Temperatur von weniger als 35 °C, besonders bevorzugt bei Raumtemperatur, erfolgt. Der Trocknungsschritt ist dadurch sehr schonend, und es wurde vorteilhafterweise die Bildung von durchgängig verbundenen netzartigen Wabenstrukturen durch die Silbernanopartikel erzielt.

In einer weiteren Ausgestaltung des Verfahrens kann die Trocknung unter (AC) für einen Zeitraum von 15 min bis 36 h erfolgen.

Im Rahmen einer weiteren bevorzugten Ausführungsform des Verfahrens kann die Abdeckung eine Glas- oder Kunststoffplatte, eine Kunststofffolie oder ein Kunststoff- oder Textilvlies, bevorzugt eine wasser- und lösungsmitteldurchlässige Abdeckung, sein.

Wird eine Abdeckung verwendet, die nicht wasser- und/oder lösungsmitteldurchlässig ist, können Wasser und/oder Lösungsmittel beispielsweise über die Randbereiche zwischen Substrat und Abdeckung entweichen. Ein Beispiel hierfür ist die Abdeckung eines mit Pickering-Emulsion beschichteten Glasobjektträgers mit einem weiteren Glasobjektträger. Wird eine derartige Substrat-Abdeckungsanordnung verwendet, wird dies erfindungsgemäß auch als Sandwichverfahren bezeichnet.

Eine wasser- und lösungsmitteldurchlässige Abdeckung kann in einer erfindungsgemäß bevorzugten Ausführungsform ein poröses Filtertuch sein. Beispielsweise kann ein Monodur Polyamid (PA) Filtertuch (Fa. VERSEIDAG) verwendet werden. Dieses steht mit verschiedenen Maschenweiten kommerziell zur Verfügung und kann je nach verwendetem Lösungsmittel angepasst verwendet werden. Vorteil eines solchen Filtertuchs ist, dass die Trocknung über die Fläche des Substrats gleichmäßiger erfolgen kann als bei einer undurchlässigen Abdeckung. Zudem kann die Trocknungszeit verkürzt werden. Vorteilhafterweise können hierbei gleich gute oder sogar bessere Ergebnisse hinsichtlich der Selbstorganisation der Silbernanopartikel zu geeigneten Netz- und Wabenstrukturen als in einem Sandwichverfahren erzielt werden. Des Weiteren haften die Silbernanopartikel vergleichsweise weniger an einer solchen Abdeckung, so dass das Risiko der Zerstörung der gebildeten, gegebenenfalls noch nicht gesinterten, Silbernanopartikel-Strukturen deutlich verringert werden kann.

In einer anderen bevorzugten Ausgestaltung des erfindungsgemäßen Verfahrens zur Teil- oder vollflächigen Beschichtung ist vorgesehen, dass es sich bei der Oberfläche um die Oberfläche eines Glas-, Metall-, Keramik- oder Kunststoffsubstrats handelt. Ein Kunststoffsubstrat kann beispielsweise aus Polyimid (PI), Polycarbonat (PC) und/oder Polyethylenterephthalat (PET) Polyurethan (PU), Polypropylen (PP) sein, die gegebenenfalls, beispielsweise zur Gewährleistung einer ausreichenden Benetzbarkeit, mit der erfindungsgemäßen Pickering-Emulsion vorbehandelt und/oder mit einem Primer versehen sein können. Vorzugsweise kann das Substrat zudem transparent sein.

Im Rahmen einer weiteren bevorzugten Ausführungsform des erfindungsgemäßen Beschichtungsverfahrens kann die Sinterung unter (AD) bei wenigstens einer Temperatur von mehr als 40°C, bevorzugt bei wenigstens einer Temperatur von 80°C bis 180°C, ganz besonders bevorzugt von 130°C bis 160°C, beispielsweise bei 140 °C, erfolgen. Vorteilhafterweise ist es durch vergleichsweise niedrige Nachbehandlungstemperaturen auch möglich, das erfindungsgemäße Beschichtungsverfahren auch für die Herstellung von transparenten elektrisch leitfähigen Strukturen auf temperaturempfindlichen Substraten, wie beispielsweise Polycarbonatfolien, einzusetzen. Erfindungsgemäß ist es vorteilhafterweise auch bei der geringen thermischen Belastung möglich, sehr gut haftende, elektronisch leitfähige Strukturen auf Substraten wie Glasträgern, aber auch Polycarbonatfolien, zu erhalten. Elektrisch leitfähige Strukturen sind hierbei insbesondere Strukturen, welche einen Widerstand von kleiner als 5000 Ω/□ aufweisen. Zudem können die erfindungsgemäß erhaltenen Beschichtungen transparent sein, was für verschiedene Anwendungen besonders vorteilhaft ist.

Ein weiterer Gegenstand der Erfindung sind elektrisch leitfähige Beschichtungen, erhalten durch ein Verfahren gemäß der vorliegenden Erfindung, wobei diese leitfähigen Beschichtungen den zusätzlichen Vorteil aufweisen, dass sie transparent sind. Solche elektrisch leitfähigen transparenten Beschichtungen können beispielsweise Leiterbahnen, Antennenelemente, Sensorelemente oder Bondverbindungen zum Kontaktieren mit Halbleiterbauelementen bilden.

Die erfindungsgemäßen transparenten und leitfähigen Beschichtungen können beispielsweise als transparente Elektroden für Displays, Bildschirme und Touchpanels, als Elektrolumineszenz-Anzeigen, als transparente Elektroden für Berührungsschalter, als transparente Abschirmungen für Elektroden und Hilfselektroden beispielsweise für Solarzellen oder in OLEDs, in Anwendungen für Kunststoffbrillengläser, als transparente Elektroden für elektrochrome Schichtsysteme oder als transparente elektromagnetische Abschirmung verwendet werden. Hierbei können vorteilhafterweise die teuren Schichten aus Zinn-dotiertem Indiumoxid (Indium Tin Oxide, ITO) und Strukturen ersetzt oder ergänzt werden.

Die folgenden Beispiele dienen der beispielhaften Erläuterung der Erfindung und sind nicht als Beschränkung aufzufassen.

### Beispiele

### Verwendete Geräte zur Durchführung der Analytik

1. Bestimmung der Ag-Konzentration mittels Feststoffwaage: METTLER TOLEDO HG53 Halogen Moisture Analyzer)
2. Bestimmung der rheologischen Eigenschaften und der Stabilität der Rahmschicht:
   Messgerät: MCR301 SN80118503
   Messsystem: CC17-SN7448; d=0 mm
   Messprofil: 21 Messpunkte;
      Messpunktdauer 30 ... 2 s log
      25°C
      d(gamma)/dt = 0,1 ... 1E+3 1/s log; |Steigung| = 5 Pkt. / dec
3. Bestimmung der Tropfengrößenverteilung und Überprüfung der Stabilität der Emulsionen mittels Lichtmikroskopie
   LEICA DMLB- Lichtmikroskop
4. Bestimmung der Oberflächenspannung mittels Ring-Tensiometer: SerNr: 20002901
5. Dispergiergerät: ULTRA- TURRAX (IKA T 25 digital ULTRA-TURRAX)
6. Dispergiergerät Ultraschallfinger (G. Heinemann, Ultraschall und Labortechnik)
7. Messung des Widerstands: Multimeter: METRA Hit 14A
8. UV-VIS-Spektrophotometer
   HEWLETT 8452 A
   PACKARD Diode Array Spektrophotometer

### Beispiel 1: Herstellung eines Silbernanopartikel-Sols (Nanosilber-Dispersion)

Es wurde eine 0,054 molare Silbernitratlösung mit einer Mischung aus einer 0,054 molaren Natronlauge und dem Dispergierhilfsmittel Disperbyk 190 (Hersteller BYK Chemie, Wesel) (1 g/l) in einem Volumenverhältnis von 1:1 1 versetzt und 10 min gerührt. Zu dieser Reaktionsmischung wurde unter Rühren eine wässrige 4,6 molare wässrige Formaldehyd-Lösung zugesetzt, so dass das Verhältnis Ag⁺ zu Reduktionsmittel 1:10 beträgt. Diese Mischung wurde auf 60 °C erwärmt, 30 min bei dieser Temperatur gehalten und anschließend abgekühlt. Die Partikel wurden in einem ersten Schritt mittels Diafiltration von den nicht umgesetzten Edukten getrennt. Anschließend wurde das Sol aufkonzentriert, dazu wurde eine Membran mit 30000 Dalton benutzt. Es entstand ein kolloidstabiles Sol mit einem Feststoffgehalt von 21,2 Gew.-% (Silberpartikel und Dispergierhilfsmittel). Der Anteil an Disperbyk 190 betrug laut Elementaranalyse nach der Membranfiltration 6 Gew.-%, bezogen auf den Silbergehalt. Eine Untersuchung mittels Laserkorrelationsspektroskopie ergab einen effektiven Partikeldurchmesser von 78 nm.

### Beispiel 2: Herstellung der Pickering-Emulsion

Das Silbernanopartikel-Sol aus Beispiel 1, Wasser und organisches Lösungsmittel wurden gemischt und mit dem Ultraschallfinger 3 min bei 50 % Amplitude behandelt, und es wurde eine O/W-Emulsion hergestellt. Nach einer Standzeit von 24 h wurde die Rahmphase charakterisiert.
Die Tropfengrößenverteilung, die Viskosität, die Oberflächenspannung der Pickering-Emulsion sowie der Feststoffgehalt an stabilisierten Silbernanopartikeln wurden ermittelt. Die Ergebnisse sind in Tab. 1 zusammengefasst.

**Tab. 1**

| Ag-Sol (21,2%) [ g ] | Wasser [ g ] | Cyclohexan [ g ] | Feststoffgehalt Ag der Rahmschicht nach 24h [%] | Tropfen-größen-verteilung [µm] | Viskosität der Rahmschicht [Pa.s] Scherrate 0,1 1/s, 25°C | Oberflächen-spannung der Rahmschicht [mN/m] |
|---|---|---|---|---|---|---|
| 7,0 | 69,0 | 24,0 | 2,5 | 1-8 | 7,12 | 49 |
| 7,0 | 73,2 | 19,8 | 2,4 | 1-8 | 15,0 | 48 |

### Beispiel 3: Beschichtung von Substraten

Die aus den Ursprungsemulsionen in Beispiel 2 hergestellten Pickering-Emulsionen wurden auf einen Glasobjektträger aufgetragen, und die gebildete Nassschicht wurde mit einem weiteren Glasobjektträger (Sandwichverfahren) oder durch Auflegung eines porösen, wasser- und lösemitteldurchlässigen Filtertuchs abgedeckt und bei Temperaturen von weniger als 35°C getrocknet. Es wurde die Ausbildung von Wabenstrukturen aus den Silbernanopartikeln in den Trockenfilmen festgestellt. Um eine Leitfähigkeit der Beschichtungen mit den Wabenstrukturen zu erreichen, wurden die Trockenfilme nach Entfernung der Abdeckung 4-12 h bei 140°C gesintert. Der Widerstand der resultierenden Beschichtung wurde mit einem Multimeter zwischen zwei ca. 0,3 cm breiten und 1 cm langen Streifen in einem Abstand von 1 cm auf den Wabenfilm gemessen. Die Transmission wurde mittels UV-VIS-Spektrophotometer bestimmt.

### Beispiel 3.1

Mit Hilfe einer Eppendorfpipette wurden 500µl der Rahmphase auf einen Glasobjektträger [25mm/75mm/1mm (b/l/h)] aufgetragen und mit einem gleichen Glasobjektträger als Deckglas (Abdeckung) abgedeckt. Danach wurde der mit dem Deckglas abgedeckte Nassfilm über Nacht bei RT getrocknet. Das Wasser sowie das organische Lösungsmittel konnten dabei über die Ränder des gebildeten Glasobjektträger-Sandwiches entweichen. Nach Entfernen des Deckglases wurde der gebildete Trockenfilm 12 h bei 140°C gesintert. Die Ausbildung einer Wabenstruktur konnte mit Lichtmikroskopie beobachtet werden.
Der Feststoffgehalt an stabilisierten Silbernanopartikeln in der Pickering-Emulsion sowie die Leitfähigkeit und Transmission der erzeugten Beschichtung wurden ermittelt:
Die Ergebnisse sind in Tab. 2 zusammengefasst.

**Tab. 2**

| Ölphase | Ag in der Rahmschicht [Gew-%]? | Widerstand [Ω] | Transmission bei 550 nm [%] |
|---|---|---|---|
| Cyclohexan | 2,4 | 48 | 50 |

### Beispiel 3.2

Mit Hilfe einer Eppendorfpipette wurden 5000µl der Rahmphase auf einen Glasobjektträger [100mm/200mm/4mm b/1/h] aufgetragen und mit einem gleichen Glasobjektträger als Deckglas (Abdeckung) abgedeckt. Danach wurde der mit dem Deckglas abgedeckte Nassfilm über fünf Tage bei RT getrocknet. Das Wasser sowie das organische Lösemittel konnten dabei über die Ränder des gebildeten Glasobjektträger-Sandwiches entweichen. Nach Entfernen des Deckglases wurde der gebildete Trockenfilm 12 h bei 140°C gesintert. Die Ausbildung einer Wabenstruktur konnte mit Lichtmikroskopie beobachtet werden.

Der Feststoffgehalt an stabilisierten Silbernanopartikeln in der Pickering-Emulsion sowie die Leitfähigkeit und Transmission der erzeugten Beschichtung wurden ermittelt: Die Ergebnisse sind in Tab. 3 zusammengefasst.

**Tab. 3**

| Ölphase | Ag in der Rahmschicht [Gew-%] | Widerstand [Ω] | Transmission bei 550 nm [%] |
|---|---|---|---|
| Cyclohexan | 2,4 | 145 | 61 |

### Beispiel 3.3

Mit Hilfe einer Eppendorfpipette wurden 5000µl der Rahmphase auf einen Glasobjektträger [100mm/200mm/4mm b/1/h] aufgetragen und mit 200µm Nassschicht aufgerakelt. Auf die nasse Schicht wurde ein Filtertuch PA 100µm Maschenweite aufgelegt. Danach wurde der mit dem Filtertuch abgedeckte Nassfilm für eine Stunde bei RT getrocknet. Das Wasser sowie das organische Lösungsmittel konnten dabei durch die Poren des Filtertuches entweichen. Nach Entfernen des Filtertuches wurde der gebildete Trockenfilm 12 h bei 140°C gesintert. Die Ausbildung einer Wabenstruktur konnte mit Lichtmikroskopie beobachtet werden.
Der Feststoffgehalt an stabilisierten Silbernanopartikeln in der Pickering-Emulsion sowie die Leitfähigkeit und Transmission der erzeugten Beschichtung wurden ermittelt.
Die Ergebnisse sind in Tab. 4 zusammengefasst.

**Tab. 4**

| Ölphase | Ag in der Rahmschicht [Gew-%] | Widerstand [Ω] | Transmission bei 550 nm [%] |
|---|---|---|---|
| Cyclohexan | 2,4 | 60 | 50 |

### Beispiel 3.4

Mit Hilfe einer Eppendorfpipette wurden 100µl der Rahmphase auf einen Glasträger [25mm/75mm/1mm (b/1/h)] pipettiert und mit 50µm Nassschicht aufgerakelt. Auf die nasse Schicht wurde ein Filtertuch PA 100µm Maschenweite aufgelegt. Danach wurde der mit dem Filtertuch abgedeckte Nassfilm für 30 min bei RT getrocknet. Das Wasser sowie das organische Lösemittel konnten dabei durch die Poren des Filtertuches entweichen. Nach Entfernen des Filtertuches wurde der gebildete Trockenfilm 12 h bei 140°C gesintert.
Dieser Versuch wurde einmal mit Cyclohexan und einmal mit n-Hexan als organischem Lösungsmittel zur Bildung der Ölphase in der Pickering-Emulsion durchgeführt.
Mit Lichtmikroskopie konnte jeweils die Ausbildung einer Wabenstruktur beobachtet werden.

Der Feststoffgehalt an stabilisierten Silbernanopartikeln in der Pickering-Emulsion sowie die Leitfähigkeit und Transmission der erzeugten Beschichtung wurden ermittelt.
Die Ergebnisse sind in Tab. 5 zusammengefasst.

**Tab. 5**

| Ölphase | Ag in der Rahmschicht [Gew-%] | Widerstand [Ω] | Transmission bei 550 nm [%] |
|---|---|---|---|
| Cyclohexan | 2,2 | 11 | 61 |
| n-Hexan | 2,6 | 27 | 48 |

### Beispiel 3.5

Analoge Beschichtungsversuche zu den vorstehenden Beispielen mittels Aufrakeln oder Spray Coating auf unbehandelte Polycarbonat-Folie waren aufgrund schlechter Benetzung erfolglos.

### Beispiel 3.6

Mit Hilfe einer Eppendorfpipette wurden 1000µl der Rahmschicht auf eine mit TiOx beschichtete Polycarbonat-Folie [100mm/100 mm/0,17mm (b/1/h)] aufgetragen und mit 100µm Nassschicht aufgerakelt, wobei eine gute Benetzung erzielt wurde. Auf die nasse Schicht wurde ein Filtertuch PA 100µm Maschenweite aufgelegt. Danach wurde der mit dem Filtertuch abgedeckte Nassfilm für eine Stunde bei RT getrocknet. Das Wasser sowie das organische Lösungsmittel konnten dabei durch die Poren des Filtertuches entweichen. Nach Entfernen des Filtertuches wurde der gebildete Trockenfilm 12 h bei 140°C gesintert. Dieser Versuch wurde einmal mit Cyclohexan und einmal mit Methylcyclohexan als organischem Lösungsmittel zur Bildung der Ölphase in der Pickering-Emulsion durchgeführt. Die Ausbildung einer Wabenstruktur konnte mit Lichtmikroskopie beobachtet werden.
Der Feststoffgehalt an stabilisierten Silbernanopartikeln in der Pickering-Emulsion sowie die Leitfähigkeit und Transmission der erzeugten Beschichtung wurden ermittelt:
Die Ergebnisse sind in Tab. 6 zusammengefasst.

**Tab. 6**

| Ölphase | Ag in der Rahmschicht [Gew-%] | Widerstand [Ω] | Transmission bei 550 nm [%] |
|---|---|---|---|
| Cyclohexan | 2,4 | 15 | 40 |
| Methylcyclohexan | 2,7 | 133 | 40 |

### Beispiel 4: Einfluss der Silberkonzentration

Die im Folgenden aufgeführten Mischungen wurden wie in Beispiel 2 beschrieben hergestellt und anschließend wie in Beispiel 3 aufgetragen, getrocknet und gesintert. Der Gehalt an Silbernanopartikeln in der Emulsion wurde ermittelt. Dann wurden zwei Silberpunkte mit einer Silberpaste in einem Abstand vom 1 cm auf die leitfähige Beschichtung aufgetragen, und der Widerstand wurde bestimmt. Außerdem wurde mit dem Lichtmikroskop die Tropfengröße der Emulsion bestimmt. Die Ergebnisse sind in Tab. 1 zusammengefasst.

**Tab. 7**

| Wasser [g] | Ag-Sol (21,2%) [ g ] | Cyclohexan [ g ] | Feststoffgehalt Ag der Rahmschicht nach 24h [Gew.-%] | Tropfengrößen-verteilung [µm] | Widerstand [Ω] |
|---|---|---|---|---|---|
| 75,0 | 1,0 | 24,0 | 0,4 | 15-50 | Keine Leitfähigkeit |
| 68,0 | 8,0 | 24,0 | 2,4 | 1-8 | 5 |

### Beispiel 5: Analyse des Silbergehalts in der Rahmphase (Pickering-Emulsion)

Zunächst wurde analog zu Beispiel 1 ein Ag-Sol hergestellt, welches einen Feststoffgehalt an Silbernanopartikeln von 18,5 % aufwies.
Dann wurden analog zu Beispiel 2 die Pickering-Emulsionen (Ultraschallfinger 3 min bei 50% Amplitude) hergestellt und der Feststoffgehalt an stabilisierten Silbernanopartikeln wurde jeweils nach 20 h und nach fünf Tagen bestimmt. Es konnte gezeigt werden, dass gerade bei vergleichsweise niedrigen Ausgangskonzentrationen an Silbernanopartikelsol in der Ursprungsemulsion vorteilhafterweise eine Aufkonzentration an stabilisierten Silbernanoperartikeln in der Rahmphase erhalten werden kann.
Die Ergebnisse sind in Tab. 8 zusammengefasst.

**Tab. 8**

| Wasser [g] | Ag-Sol (18,5%) [g] | Cyclohexan [g] | Feststoffgehalt der Rahmschicht nach 20h | Feststoffgehalt der Rahmschicht nach 5 Tagen | Feststoffgehalt in Ursprungsemulsion berechnet (Gew.-%) |
|---|---|---|---|---|---|
| 72,0 | 4,0 | 24,0 | 1,33 | 1,10 | 0,74 |
| 68,0 | 8,0 | 24,0 | 2,05 | 2,01 | 1,48 |
| 64,0 | 12,0 | 24,0 | 2,45 | 2,33 | 2,22 |
| 60,0 | 16,0 | 24,0 | 2,76 | 2,74 | 2,96 |
| 49,0 | 27,0 | 24,0 | 3,08 | 3,98 | 5,0 |

## Patentansprüche

1. Verfahren zur Herstellung einer Pickering-Emulsion zur Herstellung leitfähiger Beschichtungen, **dadurch gekennzeichnet, dass**
a) eine wässrige Dispersion enthaltend, insbesondere sterisch, stabilisierte Silbernanopartikel und Wasser mit wenigstens einem, nicht mit Wasser mischbaren, Lösungsmittel gemischt und anschließend zu einer Emulsion dispergiert wird, wobei der Gehalt an stabilisierten Silbernanopartikeln, bezogen auf das Gesamtgewicht der erhaltenen Emulsion, zwischen 0,5 Gew.-% und 7 Gew.-% liegt, und
b) anschließend während einer Standzeit die in (a) erhaltene Emulsion durch eine Aufrahmung in eine obere aufkonzentrierte Emulsionsphase und eine untere, im Wesentlichen wässrige, Phase separiert wird, und
c) die erhaltene obere aufkonzentrierte Emulsionsphase isoliert wird, wobei diese Emulsionsphase einen Gehalt an Silbernanopartikeln bis zu 7 Gew-%, bevorzugt bis zu 4,5 Gew.-%, bezogen auf deren Gesamtgewicht, aufweist.

2. Verfahren gemäß Anspruch 1, **dadurch gekennzeichnet, dass** die Standzeit unter (b) 1 Stunde bis 5 Tage beträgt.

3. Verfahren gemäß Anspruch 1 oder 2, **dadurch gekennzeichnet, dass** der Gehalt an Silbernanopartikeln der Emulsion unter (a), bezogen auf das Gesamtgewicht der unter (a) erhaltenen Emulsion, zwischen 0,7 Gew.-% und 6,5 Gew.-% liegt.

4. Pickering-Emulsion zur Herstellung leitfähiger Beschichtungen, insbesondere hergestellt nach einem Verfahren nach einem der Ansprüche 1 bis 3, **dadurch gekennzeichnet, dass** die Emulsion stabilisierte Silbernanopartikel, Wasser sowie wenigstens ein organisches nicht mit Wasser mischbares Lösungsmittel enthält, wobei die stabilisierten Silbernanopartikel in einer Menge von 0,5 Gew.-% bis 7 Gew.-%, bezogen auf das Gesamtgewicht der Emulsion, enthalten sind.

5. Pickering-Emulsion gemäß Anspruch 4, **dadurch gekennzeichnet, dass** sie keine zusätzlichen oberflächenaktiven Verbindungen, Bindemittel, Polymere, Filmbildner, Puffer oder Dispergiermittel enthält.

6. Pickering-Emulsion gemäß Anspruch 4 oder 5, **dadurch gekennzeichnet, dass** es sich bei dem organischen Lösungsmittel um wenigstens ein lineares oder verzweigtes Alkan, ein gegebenenfalls Alkyl-substituiertes Cycloalkan, ein Alkylacetat oder ein Keton, Benzol oder Toluol handelt.

7. Pickering-Emulsion gemäß wenigstens einem der Ansprüche 4 bis 6, **dadurch gekennzeichnet, dass** das organische Lösungsmittel und das Wasser in der Emulsion in einem Volumen-Verhältnis 1:4 bis 1:2 enthalten sind.

8. Pickering-Emulsion gemäß wenigstens einem der Ansprüche 4 bis 7, **dadurch gekennzeichnet, dass** die Silbernanopartikel sterisch stabilisiert sind.

9. Verfahren zum voll- oder teilflächigen Beschichten von Oberflächen, **dadurch gekennzeichnet, dass**
AA) eine Pickering-Emulsion gemäß wenigstens einem der Ansprüche 4 bis 7 voll- oder teilflächig auf eine Oberfläche aufgebracht wird,
AB) die so beschichtete Oberfläche anschließend mit einer Abdeckung derart abgedeckt wird, dass Wasser und Lösungsmittel entweichen können,
AC) die so abgedeckte, beschichtete Oberfläche anschließend bei wenigstens einer Temperatur von weniger als 40 °C getrocknet wird,
AD) die so getrocknete Beschichtung anschließend in Gegenwart oder Abwesenheit der Abdeckung gesintert wird.

10. Verfahren gemäß Anspruch 9, **dadurch gekennzeichnet, dass** die Trocknung unter (AC) bei wenigstens einer Temperatur von weniger als 35 °C, bevorzugt bei Raumtemperatur, erfolgt.

11. Verfahren gemäß Anspruch 9 oder 10, **dadurch gekennzeichnet, dass** die Trocknung unter (AC) für einen Zeitraum von 15 min bis 36 h erfolgt.

12. Verfahren gemäß wenigstens einem der Ansprüche 9 bis 11, **dadurch gekennzeichnet, dass** es sich bei der Abdeckung um eine Glas- oder Kunststoffplatte, eine Kunststofffolie oder ein Kunststoff- oder Textilvlies, bevorzugt um eine wasser- und lösungsmitteldurchlässige Abdeckung, handelt.

13. Verfahren gemäß wenigstens einem der Ansprüche 9 bis 12, **dadurch gekennzeichnet, dass** es sich bei der Oberfläche um die Oberfläche eines Glas-, Metall-, Keramik- oder Kunststoffsubstrats handelt.

14. Verfahren gemäß wenigstens einem der Ansprüche 9 bis 13, **dadurch gekennzeichnet, dass** die Sinterung unter (AD) bei wenigstens einer Temperatur von mehr als 40°C, bevorzugt bei wenigstens einer Temperatur in einem Bereich von 80°C bis 180°C erfolgt.

15. Leitfähige Beschichtung hergestellt nach einem Verfahren gemäß einem der Ansprüche 9 bis 14, **dadurch gekennzeichnet, dass** sie transparent ist.
